# EUROPEAN PATENT SPECIFICATION

(11) **EP 4 571 339 B1**
(45) Date of publication and mention of the grant of the patent: **29.04.2026**
(21) Application number: 23868396.5
(22) Date of filing: 10.08.2023
(51) Int. Cl.: G01R 31/382, G01R 31/367, G01R 31/396, G01R 31/385, G01L 9/08, G01L 19/08, G01R 19/12, G01R 19/165, H01M 10/052, B60L 58/12, G01R 31/36, H01M 10/42, H01M 10/48, G01R 31/3842

(54) **BATTERY MANAGEMENT SYSTEM, BATTERY PACK, ELECTRIC VEHICLE, AND BATTERY MANAGEMENT METHOD**
BATTERIEVERWALTUNGSSYSTEM, BATTERIEPACK, ELEKTROFAHRZEUG UND BATTERIEVERWALTUNGSVERFAHREN
SYSTÈME DE GESTION DE BATTERIE, BLOC-BATTERIE, VÉHICULE ÉLECTRIQUE ET PROCÉDÉ DE GESTION DE BATTERIE

(30) Priority: 23.09.2022 KR 20220120521; 15.05.2023 KR 20230062661
(43) Date of publication of application: 18.06.2025
(73) Proprietor: LG Energy Solution, Ltd., Seoul 07335 (KR)
(72) Inventor: HONG, Kyung-Sik, Daejeon 34122 (KR); KIM, Hyeon-Jin, Daejeon 34122 (KR); PARK, Gi-Su, Daejeon 34122 (KR); AHN, Ji-Hoon, Daejeon 34122 (KR)
(74) Representative: Goddar, Heinz J.
(86) International application number: PCT/KR2023/011878
(87) International publication number: WO 2024/063337

(56) References cited:
- KR-A- 20130 028 664
- KR-A- 20180 021 570
- KR-A- 20210 074 005
- KR-A- 20220 093 842
- US-A1- 2017 261 560
- JIANG YIHUI ET AL: "An electromechanical coupling model-based state of charge estimation method for lithium-ion pouch battery modules", ENERGY, ELSEVIER, AMSTERDAM, NL, vol. 259, 4 August 2022 (2022-08-04), XP087184592, ISSN: 0360-5442, [retrieved on 20220804], DOI: 10.1016/J.ENERGY.2022.125019

## Description

### TECHNICAL FIELD

The present disclosure relates to a technology for estimating a SOC (State Of Charge) of a battery cell.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Battery packs for applications that require large capacity and high voltage, such as electric vehicles or energy storage systems, include dozens to hundreds of battery cells connected in series. The battery management system is provided to obtain battery parameters (e.g., voltage, current, SOC, etc.) of each battery cell and execute various functions (e.g., balancing, cooling) to ensure the reliability and safety of each battery.

Currently, various types of rechargeable battery cells are widely used, and some types of battery cells, such as LFP cells and LiS cells, have flat characteristics in a portion of the entire SOC (State Of Charge) range (e.g., SOC 20 to 80%). The flat characteristic is that the change amount of OCV relative to the change amount of SOC is extremely small, and can be recorded as a data set (e.g., SOC-OCV curve) showing the relationship between SOC and OCV (Open Circuit Voltage).

If a battery cell has a flat SOC range, even if the SOC-OCV curve (sometimes referred to as an 'OCV map') may be useful for estimating SOC outside the flat SOC range, since a large difference is caused between the estimated value of SOC and the actual value within that SOC range even with a small measurement error of OCV, it is difficult to accurately determine the SOC of a battery cell during charging and discharging by using only the SOC-OCV curve. Therefore, when the SOC of the battery cell is within the plateau section (SOC range with flat characteristics), it is preferred to determine the SOC of the battery cell based on the ampere integration amount of the battery cell instead of the SOC-OCV curve.

However, when the SOC of the battery cell is maintained for a long time within the plateau section while alternately performing charging and discharging, the error between the actual value of the current of the battery cell and the detected value continues to accumulate in the ampere integration amount, so the estimation accuracy of SOC gradually deteriorates.

One solution to this problem is to intentionally charge or discharge the battery cell so that the SOC of the battery cell deviates from the plateau section, and then estimate the SOC based on the OCV of the battery cell using the SOC-OCV curve.

However, the above-described method has a problem in that power is unnecessarily wasted due to intentional charging or discharging of the battery cell, and the time required to estimate SOC is correspondingly prolonged.

Y. Jiang, J. Xu, M. Liu, and X. Mei, "An electromechanical coupling model-based state of charge estimation method for lithium-ion pouch battery modules," Energy, vol. 259, p. 125019, Aug. 2022, doi: 10.1016/j.energy.2022.125019, discloses improving the performance of SOC estimation by using multi-dimensional signals, wherein an electromechanical coupling model of a lithium-ion pouch battery module is established.

### DISCLOSURE

### Technical Problem

The present disclosure is designed to solve the problems of the related art, and therefore the present disclosure is directed to providing a battery management system, a battery pack, an electric vehicle, and a battery management method, which prevent the estimation accuracy of the SOC of the battery cell from deteriorating even if a situation occurs where the SOC of the battery cell enters the plateau section during the process of charging or discharging the battery cell.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

### Technical Solution

A battery management system according to one aspect of the present disclosure is for a battery cell having a plateau section that is a SOC (State Of Charge) range in which a change rate of OCV (Open Circuit Voltage) is maintained at a reference value or less. The battery management system comprises a sensing unit configured to detect voltage, current, and pressure of the battery cell; a memory configured to store first relationship data representing a relationship between OCV and SOC of the battery cell and second relationship data representing the relationship between pressure and SOC of the battery cell; and a control unit configured to determine a voltage value representing the detected voltage, a current value representing the detected current, and a pressure value representing the detected pressure, and determine a SOC estimation value of the battery cell at each set time.

The control unit is configured to compare a previous SOC estimation value with the plateau section, and according to the result of the comparison, determine a current SOC estimation value to be equal to any one of or a weighted average of two of (i) a first SOC estimation value obtained using a first SOC estimation logic based on the voltage value, the current value and the first relationship data, and (ii) a second SOC estimation value obtained using a second SOC estimation logic based on the pressure value and the second relationship data.

The control unit may be configured to determine the current SOC estimation value to be equal to the first SOC estimation value, when the previous SOC estimation value is outside the plateau section.

The control unit may be configured to determine the current SOC estimation value to be equal to the second SOC estimation value, when the previous SOC estimation value is within the plateau section.

When the previous SOC estimation value is outside the plateau section, the control unit may be configured to determine a first weight associated with the first SOC estimation logic and a second weight associated with the second SOC estimation logic based on a difference between a lower limit or an upper limit of the plateau section and the previous SOC estimation value, and determine the current SOC estimation value to be equal to a first weighted average of the first SOC estimation value and the second SOC estimation value based on the first weight and the second weight.

The first weight may have a negative correlation to the difference between the lower limit or the upper limit of the plateau section and the previous SOC estimation value, and the second weight may have a positive correlation to the difference between the lower limit or the upper limit of the plateau section and the previous SOC estimation value.

When the previous SOC estimation value is within the plateau section, the control unit may be configured to determine the current SOC estimation value to be equal to a second weighted average of the first SOC estimation value and the second SOC estimation value based on a third weight associated with the first SOC estimation logic and a fourth weight associated with the second SOC estimation logic. The third weight may be less than the first weight. The fourth weight may be greater than the second weight.

When the previous SOC estimation value is within the plateau section, the control unit may be configured to determine a stay time of the SOC estimation value within the plateau section based on a time series of the SOC estimation value. The control unit may be configured to correct a third weight associated with the first SOC estimation logic and a fourth weight associated with the second SOC estimation logic based on the stay time. The control unit may be configured to determine the current SOC estimation value to be equal to a second weighted average of the first SOC estimation value and the second SOC estimation value based on the corrected third weight and the corrected fourth weight. The third weight may be less than the first weight. The fourth weight may be greater than the second weight.

The corrected third weight may be less than or equal to the third weight. The corrected fourth weight may be greater than or equal to the fourth weight. The difference between the corrected third weight and the third weight and the difference between the corrected fourth weight and the fourth weight may have a positive correlation to the stay time, respectively.

When the previous SOC estimation value is outside the plateau section, the control unit may be configured to determine a first weight associated with the first SOC estimation logic and a second weight associated with the second SOC estimation logic based on a difference between the lower limit or the upper limit of the plateau section and the previous SOC estimation value. The control unit may be configured to determine a stay time of the SOC estimation value outside the plateau section based on a time series of the SOC estimation value. The control unit may be configured to correct the first weight and the second weight based on the stay time. The control unit may be configured to determine the current SOC estimation value to be equal to a first weighted average of the first SOC estimation value and the second SOC estimation value based on the corrected first weight and the corrected second weight. The third weight may be less than the first weight. The fourth weight may be greater than the second weight.

A battery pack according to another aspect of the present disclosure may comprise the battery management system.

An electric vehicle according to still another aspect of the present disclosure may comprise the battery pack.

A battery management method according to still another aspect of the present disclosure is provided to be executed at each set time by the battery management system. The battery management method comprises: determining a voltage value representing a voltage of the battery cell, a current value representing a current of the battery cell, and a pressure value representing a pressure of the battery cell; comparing a previous SOC estimation value of the battery cell having the plateau section; and according to the result of the comparison, determining a current SOC estimation value of the battery cell to be equal to any one of or a weighted average of two of (i) a first SOC estimation value obtained using a first SOC estimation logic based on the voltage value, the current value and the first relationship data, and (ii) a second SOC estimation value obtained using a second SOC estimation logic based on the pressure value and the second relationship data.

The step of determining a current SOC estimation value of the battery cell may determine the current SOC estimation value to be equal to the first SOC estimation value, when the previous SOC estimation value is outside the plateau section. The step of determining a current SOC estimation value of the battery cell may determine the current SOC estimation value to be equal to the second SOC estimation value, when the previous SOC estimation value is within the plateau section.

The step of determining a current SOC estimation value of the battery cell may include: when the previous SOC estimation value is outside the plateau section, determining a first weight associated with the first SOC estimation logic and a second weight associated with the second SOC estimation logic based on a difference between a lower limit or an upper limit of the plateau section and the previous SOC estimation value, and determining the current SOC estimation value to be equal to a first weighted average of the first SOC estimation value and the second SOC estimation value based on the first weight and the second weight.

The step of determining a current SOC estimation value of the battery cell may include: when the previous SOC estimation value is within the plateau section, obtaining a third weight associated with the first SOC estimation logic and a fourth weight associated with the second SOC estimation logic, and determining the current SOC estimation value to be equal to a second weighted average of the first SOC estimation value and the second SOC estimation value based on the third weight and the fourth weight. The third weight may be less than the first weight. The fourth weight may be greater than the second weight.

### Advantageous Effects

According to at least one of the embodiments of the present disclosure, even if a situation occurs where the SOC of the battery cell enters the plateau section during the process of charging or discharging the battery cell, the estimation accuracy of the SOC of the battery cell can be prevented from deteriorating.

In addition, according to at least one of the embodiments of the present disclosure, instead of estimating the SOC of the battery by solely using the SOC-OCV curve (corresponding to the 'first relationship data' in the claims), the SOC-P curve (corresponding to the 'second relationship data' in the claims), which represents the relationship between SOC and pressure of the battery is additionally utilized, so that the SOC estimation accuracy can be improved in the entire SOC range including the plateau section.

In addition, according to at least one of the embodiments of the present disclosure, depending on the difference between the SOC estimation value of the battery and the lower limit or the upper limit of the plateau section, the SOC estimation value at each set time is calculated by combining the first SOC estimation value based on the first relationship data and the second SOC estimation value based on the second relationship data to have different influences, so that the SOC estimation accuracy in the entire SOC range can be improved.

In addition, according to at least one of the embodiments of the present disclosure, the SOC estimation value of the battery at each set time is calculated by combining the first SOC estimation value based on the first relationship data and the second SOC estimation value based on the second relationship data to have different influences based on the stay time during which the SOC estimation value of the battery stays within or outside the plateau section, so that the SOC estimation accuracy in the entire SOC range can be improved.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a drawing illustrating the configuration of an electric vehicle according to the present disclosure.
FIG. 2 is a graph showing an example of the SOC-OCV curve of a battery cell.
FIG. 3 is a graph showing an example of the SOC-P curve of a battery cell.
FIG. 4 is a graph showing an example of the SOH-P curve of a battery cell.
FIG. 5 is a flowchart illustrating a battery management method executed by the battery management system shown in FIG. 1.
FIG. 6 is a flowchart illustrating the subroutine of step S530 of FIG. 5.
FIG. 7 is a flowchart illustrating another subroutine of step S530 of FIG. 5.
FIG. 8 is an example of a weight map that can be used in the subroutine of FIG. 7.
FIG. 9 is a flowchart illustrating still another subroutine of step S530 of FIG. 5.
FIG. 10 is an example of a weight map that can be used in the subroutine of FIG. 9.
FIG. 11 is a flowchart illustrating still another subroutine of step S530 of FIG. 5.
FIG. 12 is an example of a weight map that can be used in the subroutine of FIG. 11.

### BEST MODE

Hereinafter, preferred embodiments of the present disclosure will be described in detail with reference to the accompanying drawings. Prior to the description, it should be understood that the terms used in the specification and the appended claims should not be construed as limited to general and dictionary meanings, but interpreted based on the meanings and concepts corresponding to technical aspects of the present disclosure on the basis of the principle that the inventor is allowed to define terms appropriately for the best explanation.

Therefore, the description proposed herein is just a preferable example for the purpose of illustrations only, not intended to limit the scope of the disclosure, so it should be understood that modifications could be made thereto without departing from the scope of the disclosure.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise. Additionally, terms such as "... unit" described in the specification refer to a unit that processes at least one function or operation, and may be implemented as hardware, software, or a combination of hardware and software.

In addition, throughout the specification, when a portion is referred to as being "connected" to another portion, it is not limited to the case that they are "directly connected", but it also includes the case where they are "indirectly connected" with another element being interposed between them.

In this specification, SOC (State Of Charge) refers to the ratio of the remaining capacity to the fully charged capacity of a storage capable unit (e.g., battery cell, cell group) expressed as 0 to 100%.

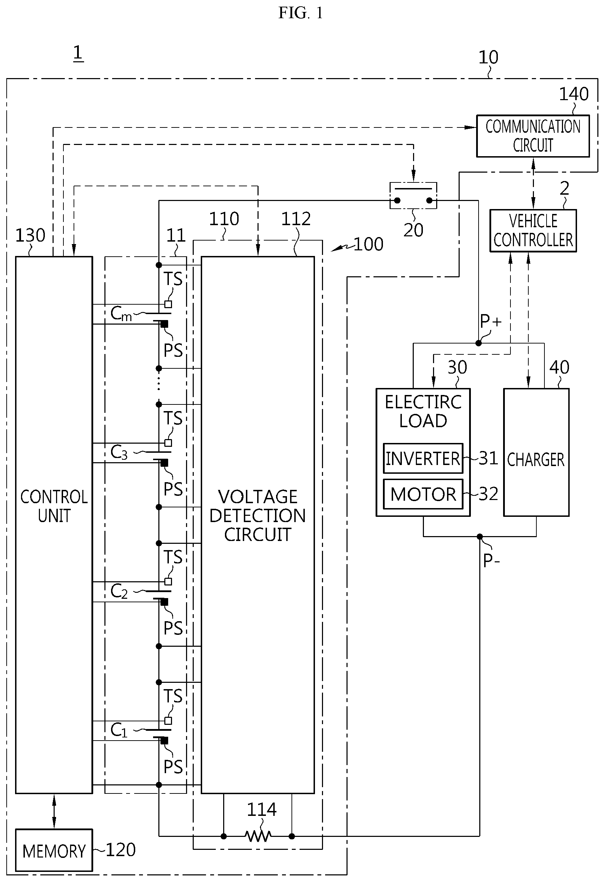

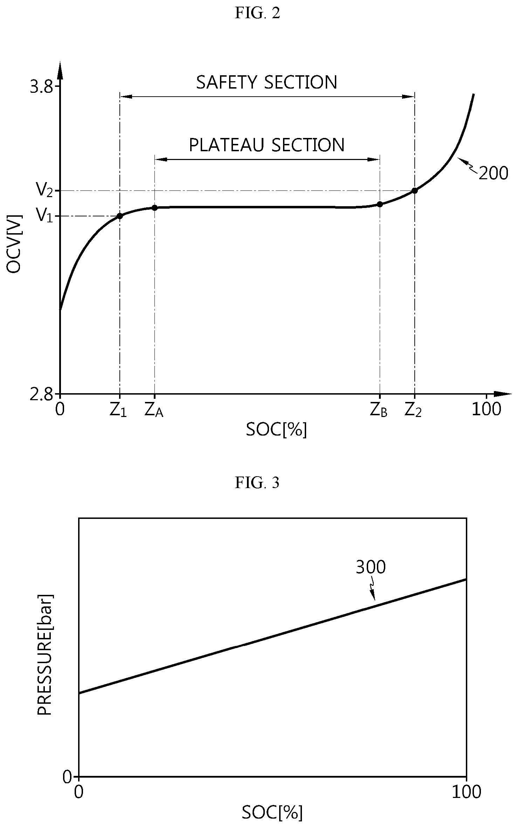

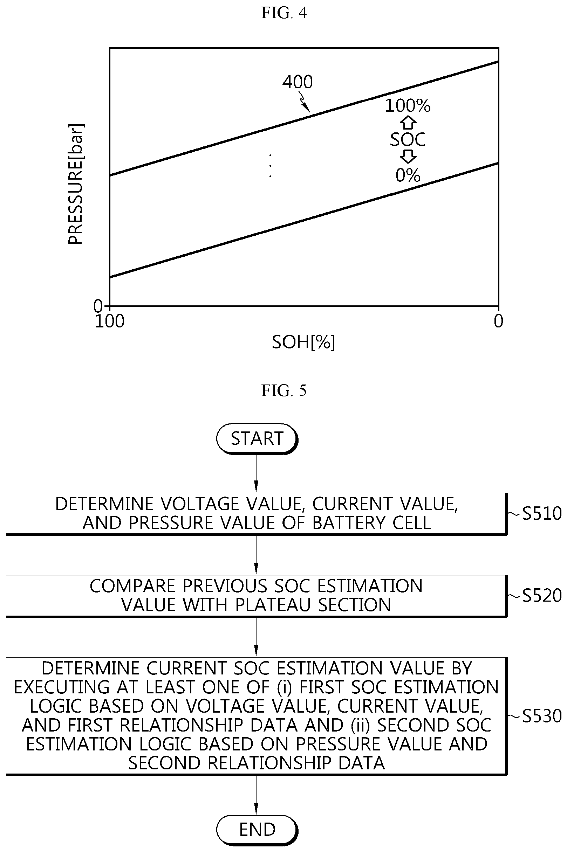

FIG. 1 is a drawing illustrating the configuration of an electric vehicle according to the present disclosure, FIG. 2 is a graph showing an example of the SOC-OCV curve of a battery cell, FIG. 3 is a graph showing an example of the SOC-P curve of a battery cell, and FIG. 4 is a graph referred to in explain the relationship between the SOH and the SOH-P curve of a battery cell. In the following, when explaining common content in battery cells, the reference symbol 'C' will be assigned.

Referring to FIG. 1, the electric vehicle 1 includes a vehicle controller 2, a battery pack 10, and an electric load 30. The charging and discharging terminals P+, P- of the battery pack 10 can be electrically connected to the charger 40 through a charging cable, etc. The charger 40 may be included in the electric vehicle 1 or may be provided at the charging station outside the electric vehicle 1.

The vehicle controller 2 (e.g., ECU: Electronic Control Unit) is configured to transmit a key-on signal to the battery management system 100 in response to the start button (not shown) provided in the electric vehicle 1 being switched to the ON position by the user. The vehicle controller 2 is configured to transmit a key-off signal to the battery management system 100 in response to the start button being switched to the OFF position by the user. The charger 40 can communicate with the vehicle controller 2 and supply charging power (e.g., constant current, constant voltage, constant power) through the charging and discharging terminals P+, P- of the battery pack 10.

The battery pack 10 includes a cell group 11, a relay 20, and a battery management system 100.

The cell group 11 includes at least one battery cell C. FIG. 1 illustrates that a plurality of battery cells (C₁ to Cₘ, m is a natural number of 2 or more) connected in series are included in the cell group 11. When explaining common content in the plurality of battery cells (C₁ to Cₘ), the symbol C will be used.

In the cell group 11, each of the plurality of battery cells (C₁ to Cₘ) has a positive electrode lead and a negative electrode lead, and the positive electrode lead of one (e.g., C₁) of two adjacent battery cells (e.g., C₁, C₂) is connected to the negative electrode lead of the other (e.g. C₂) by welding, etc. Accordingly, a series connection body from the negative electrode lead of the battery cell (C₁) to the positive electrode lead of the battery cell (Cₘ) is disposed in the cell group 11. Hereinafter, it should be noted in advance that the positive electrode lead and the negative electrode lead of the battery cell C may be referred to as 'positive electrode' and 'negative electrode', respectively.

The plurality of battery cells (C1 to Cm) may be manufactured to have the same electrochemical specifications and charging and discharging characteristics. The type of the battery cell C is not particularly limited as long as it can be repeatedly charged and discharged like an LFP battery and has flat characteristics.

The series circuit of the cell group 11 and the current detection element 114 is electrically connected to the electric load 30 and/or the charger 40 through the relay 20.

The relay 20 is installed on the power line PL, which serves as a current path for charging and discharging the battery pack 10. While the relay 20 is on, power can be transferred from either the battery pack 10 or the electric load 30 to the other. The relay 20 may be implemented by using any one or a combination of two or more of known switching devices such as a mechanical contactor, a field effect transistor (FET), etc. The control unit 130 may control the relay 20 from one of the on and off states to the other state.

The electric load 30 includes an inverter 31 and an electric motor 32. The inverter 31 is provided to convert direct current from the cell group 11 included in the battery pack 10 into alternating current in response to commands from the battery management system 100 or the vehicle controller 2. The electric motor 32 is driven using alternating current power from the inverter 31. As the electric motor 32, for example, a three-phase alternating current motor can be used.

The state in which the relay 20 is turned on and the cell group 11 is being charged and discharged can be referred to as a load state (cycle state). The voltage of the battery cell C detected in the load state can be referred to as load voltage or CCV (Closed Circuit Voltage).

When the relay 20 is switched from on to off, the cell group 11 enters a no-load state (idle state, calendar state). The voltage across both ends of the battery cell C in the no-load state can be referred to as no-load voltage. No-load voltage is a general term for relaxation voltage and OCV (Open Circuit Voltage). Specifically, when the battery cell C switches from the load state to the no-load state, the polarization generated in the battery cell C begins to be naturally resolved and the no-load voltage of the battery cell C converges toward OCV. OCV indicates a no-load voltage in which the battery cell C is maintained in a no-load state for a predetermined time (e.g., 2 hours) or more and the voltage change rate of the battery cell C is less than a certain value. In other words, OCV is the no-load voltage in a state where the polarization of the battery cell C is negligibly small. The relaxation voltage represents the no-load voltage before polarization becomes sufficiently small.

The battery management system 100 is provided to monitor the state of each of the plurality of battery cells (C₁ to Cₘ).

The battery management system 100 includes a sensing unit 110, a memory 120, and a control unit 130. The battery management system 100 may further include a communication unit 140.

The sensing unit 110 includes a voltage detection circuit 112, a current detection circuit 114, and a plurality of pressure sensors PS. The sensing unit 110 may further include a plurality of temperature sensors TS.

The voltage detection circuit 112 is provided to be electrically connected to the positive and negative electrodes of each of the plurality of battery cells (C₁ to Cₘ). The voltage detection circuit 112 detects the voltage across both ends of the battery cell C (hereinafter simply referred to as 'battery cell voltage' or 'cell voltage) using the potential difference between a pair of sensing lines connected to the positive and negative electrodes of the battery cell C, respectively. The voltage detection circuit 112 may transmit a voltage signal indicating the detected cell voltage of the battery cell C to the control unit 130 through analog-to-digital conversion.

The current detection circuit 114 is connected in series to the cell group 11 through a current path between the cell group 11 and the electric load 30. The current detection circuit 114 may be implemented with one or a combination of two or more of known current detection elements such as a shunt resistor, Hall effect element, etc. Since the plurality of battery cells (C₁ to Cₘ) are connected in series, charging and discharging currents of the same size and in the same direction flow through the plurality of battery cells (C₁ to Cₘ).

FIG. 1 illustrates that a shunt resistor is used as the current detection circuit 114. In this case, the voltage detection circuit 112 may output a current signal indicating the direction and size of the charging and discharging current to the control unit 130 based on the voltage across both ends of the shunt resistor. Of course, the current detection circuit 114 may be provided to directly generate a current signal indicating the charging and discharging current flowing through the cell group 11 and output it to the control unit 130.

The plurality of pressure sensor PS can be provided on a one-to-one basis to the plurality of battery cells (C₁ to Cₘ). As the pressure sensor PS, for example, a piezoelectric element can be used. The cell group 11 may include a plurality of support plates (not shown), and the plurality of support plates form a space where each of the plurality of battery cells (C₁ to Cₘ) can be seated independently. The pressure sensor PS may be located between the exterior material of the battery cell C and the support plate of the cell group 11. The battery cell C may expand and contract due to expansion of the electrode plates contained therein or gases. For example, as the expansion amount of the battery cell C increases, the exterior material of the battery cell C moves closer toward the support plate, so the pressure acting on the pressure sensor PS increases. The pressure sensor PS may be configured to output to the control unit 130 a pressure signal indicating the pressure applied to the pressure sensor PS according to a change in volume due to expansion (swelling) of the battery cell C.

The plurality of temperature sensors TS may be installed in one-to-one correspondence with the plurality of battery cells (C₁ to Cₘ). The temperature sensor TS may be attached directly to the exterior material of the battery cell C or may be arranged to be spaced apart a certain distance. The temperature sensor TS may be configured to output a temperature signal indicating the temperature of the battery cell C to the control unit 130. As the temperature sensor TS, for example, a thermocouple can be used.

In the memory 120, programs and various data necessary for executing the battery management method according to embodiments to be described later may be stored in advance. The memory may include, for example, at least one type computer-readable storage medium selected from, for example, flash memory type, hard disk type, SSD (Solid State Disk) type, SDD (Silicon Disk Drive) type, multimedia card micro type, RAM (random access memory), SRAM (static random access memory), ROM (read-only memory), EEPROM (electrically erasable programmable read-only memory), or PROM (programmable read-only memory).

The control unit 130 is operably coupled to the relay 20, the sensing unit 110, the memory 120, and/or the communication unit 140. The operational coupling of two components means that the two components are connected directly or indirectly to enable transmission and reception of signals in one direction or two directions.

The control unit 130 may be implemented, in terms of hardware, using at least one of DSPs (digital signal processors), DSPDs (digital signal processing devices), PLDs (programmable logic devices), FPGAs (field programmable gate arrays), microprocessors, and other electrical units to perform functions.

The control unit 130 determines the voltage value, the current value, the temperature value, and the pressure value based on the voltage signal, the current signal, the temperature signal, and the pressure signal received from the sensing unit 110 at each set time (e.g., 0.01 seconds). These values can be recorded in the memory 120. Since the current signal includes direction information of the current, the control unit 130 can determine whether the battery pack 10 is being charged, being discharged, or being idle based on the current signal. Idle (or idle state) means that both charging and discharging of the battery pack 10 are stopped.

The control unit 130 may determine the ampere integration amount based on the current signal using ampere counting (current integration method). The ampere integration amount at a certain time point represents the total amount of current accumulated over the period from the last time the ampere integration amount was initialized before the corresponding time point to the corresponding time point.

The communication unit 140 may be communicatively coupled with the vehicle controller 2 of the electric vehicle 1. The communication unit 140 may transmit a message from the vehicle controller 2 to the control unit 130 and transmit a message from the control unit 130 to the vehicle controller 2. The message from the control unit 130 may include information for notifying the state of the battery cell C (e.g., voltage, SOC, overdischarge, low voltage, overcharge, overvoltage). For communication between the communication unit 140 and the vehicle controller 2, for example, a wired network such as LAN (local area network), CAN (controller area network), and daisy chain, and/or a short-range wireless network such as Bluetooth, ZigBee, or Wi-Fi can be utilized. The battery management system 100 may further include an output device (e.g., display, speaker) that provides information received by the communication unit 140 from the control unit 130 and/or the vehicle controller 2 in a form recognizable to the user. The vehicle controller 2 may control the electric load 30 based on the information collected through communication with the battery management system 100.

Referring to FIG. 2, the first relationship data including the SOC-OCV curve 200 is stored in the memory 120. Plateau section (Z_{A} to Z_{B}) is recorded in the SOC-OCV curve 200.

If the plurality of temperature sections are predefined, the first relationship data designed individually for each temperature section may be recorded in the memory 120. The control unit 130 may obtain the first relationship data associated with a single temperature section to which the temperature value of the battery cell C belongs among the plurality of temperature sections from the memory 120 and use it for SOC estimation. Similarly, when the plurality of SOH (State Of Health) sections are predefined, the memory 120 may contain the first relationship data designed individually for each SOH section. The control unit 130 may obtain the first relationship data associated with a single SOH section to which the SOH of the battery cell C belongs among the plurality of SOH sections from the memory 120 and use it for SOC estimation. For example, if there are 10 temperature sections and 20 SOH sections, a total of 200 first relationship data may be already stored in the memory 120.

For battery cell C, the OCV remains almost constant across the plateau section (Z_{A} to Z_{B}). That is, in the plateau section (Z_{A} to Z_{B}), the change rate (e.g., differential value) of OCV with respect to SOC is maintained at a predetermined reference value or less. On the other hand, in the remaining range (0 to Z_{A} %, Z_{B} to 100%) outside the plateau section (Z_{A} to Z_{B}), the change rate of OCV to SOC is greater than the predetermined reference value. Accordingly, when the OCV is specified, the SOC corresponding to the specified OCV can be determined with high accuracy from the SOC-OCV curve 200.

It is known that most rechargeable batteries, including the battery cell C, have the characteristic of being degraded relatively quickly when continuously used (charged and discharged) near 0% SOC or near 100% SOC outside the appropriate range. The safety voltage range (V₁ to V₂) is predetermined by considering the relationship between the SOC and the degradation rate of the battery cell C. The SOC (Z₁) corresponding to the lower limit (V₁) of the safety voltage range (V₁ to V₂) is smaller than the OCV corresponding to the lower limit (Z_{A}) of the plateau section. The SOC (Z₂) corresponding to the upper limit (V₂) of the safety voltage range (V₁ to V₂) is greater than the upper limit (Z_{B}) of the plateau section. The range of Z₁ to Z₂ corresponding to the safety voltage range (V₁ to V₂) can be referred to as a safety section.

While periodically calculating the SOC estimation value of the battery cell C at each set time, the control unit 130 may deactivate the pressure sensor PS if the previous SOC estimation value is smaller than the lower limit (Z_{A}) of the plateau section (Z_{A} to Z_{B}) by the set value or more, or is greater than the upper limit (Z_{B}) of the plateau section (Z_{A} to Z_{B}) by the set value or more (e.g., outside the safety range). That is, in calculating the SOC estimation value, if there is no need for the SOC-P curve 300, which will be described later, or if the necessity is very low, the pressure sensor PS is deactivated, thereby saving the power required to drive the pressure sensor PS and also reducing the computational load required for processing the pressure signal.

On the other hand, in the battery cell C, which is manufactured to include a specific material (e.g., lithium metal) in the electrode, a reaction occurs in which working ions (e.g., lithium ions) are inserted or desorbed from the lattice of the electrode during charging and discharging, thereby causing the change in volume. Accordingly, the inventor of this application recognized that the change over time in the pressure of the battery cell C detected by the pressure sensor PS has a sufficient correlation with the change over time in the SOC of the battery cell C.

Referring to FIG. 3, the second relationship data including a SOC-P (Pressure) curve 300 indicating the relationship between SOC and pressure of the battery cell C is stored in the memory 120. If the plurality of temperature sections are predefined, the second relationship data designed individually for each temperature section may be recorded in the memory 120. The control unit 130 may obtain the second relationship data associated with a single temperature section to which the temperature value of the battery cell C belongs among the plurality of temperature sections from the memory 120 and use it for SOC estimation. Similarly, if the plurality of SOH sections are predefined, the second relationship data individually designed for each SOH section may be recorded in the memory 120. The control unit 130 may obtain the second relationship data associated with a single SOH section to which the SOH of the battery cell C belongs among the plurality of SOH sections from the memory 120 and use it for SOC estimation. For example, if there are 10 temperature sections and 20 SOH sections, a total of 200 second relationship data may be already stored in the memory 120.

According to the SOC-P curve 300, it can be seen that as the SOC of the battery cell C increases from 0% to 100%, the pressure of the battery cell C also gradually increases. That is, unlike the SOC-OCV curve 200 having a plateau section described above with reference to FIG. 2, the pressure of the battery cell C has an approximately linear relationship with SOC. Therefore, while the SOC of the battery cell C is estimated to be located within the plateau section (Z_{A} to Z_{B}), the SOC of the battery cell C can be estimated with high accuracy by using the SOC-P curve 300 alone instead of the SOC-OCV curve 200, or by using a combination of the SOC-OCV curve 200 and the SOC-P curve 300.

Referring to FIG. 4, the third relationship data including the SOH-P curve 400 indicating the relationship between the SOH and pressure of the battery cell C is stored in the memory 120. If the plurality of temperature sections are predefined, the third relationship data designed individually for each temperature section may be recorded in the memory 120. The control unit 130 may obtain the third relationship data associated with a single temperature section to which the temperature value of the battery cell C belongs among the plurality of temperature sections from the memory 120 and use it for SOH estimation.

Each SOH-P curve 400 shown in FIG. 4 may be prepared in advance for different SOCs. Even if the SOC of the battery cell C is the same as a specific value, it can be seen from FIG. 3 that as the battery cell C deteriorates (i.e., as SOH decreases), the pressure of the battery cell C gradually increases approximately linearly. In addition, even if the SOH of the battery cell C is the same as a specific value, as described above, the pressure of the battery cell C gradually increases approximately linearly as the SOC of the battery cell C increases, which can also be confirmed in FIG. 3.

SOH can be estimated using any one or a combination of two or more of various known methods. As an example, the control unit 130 may calculate the current maximum capacity of the battery cell C by dividing the ampere integration amount over the period from when the SOC of the battery cell C is at the first value to when reaching the second value by the change amount of SOC (i.e., the difference between the first value and the second value). Next, the control unit 130 may determine the SOH estimation value by converting the value obtained by dividing the maximum capacity of the battery cell C by the design capacity of the battery cell C (maximum capacity of the new product) into a percentage.

When the battery cell C is in a load state, the control unit 130 may determine (estimate) the OCV of the battery cell C based on the voltage and current (temperature may be added) of the battery cell C detected by the sensing unit 110. For example, according to Ohm's law, the OCV estimation value of the battery cell C may be calculated by subtracting the voltage value corresponding to the product of the current value of the battery cell C and the internal resistance of the battery cell C from the voltage value of the battery cell C. The control unit 130 may determine the internal resistance of the battery cell C based on the ratio between the voltage change amount and the current change amount of the battery cell C at each set time, according to Ohm's law. Alternatively, it is also possible to determine the internal resistance of the battery cell C from a resistance map in which the relationship between SOC, temperature, and internal resistance of the battery cell C is defined.

FIG. 5 is a flowchart illustrating a battery management method executed by the battery management system shown in FIG. 1. The method of FIG. 5 may be periodically and repeatedly executed at each set time by the battery management system 100 when the battery cell C is charged and discharged or when the idle time during which the battery cell C is maintained in an idle state is less than a predetermined stabilization time. For reference, if the idle time is not long enough, even if it is in an idle state, the no-load voltage of the battery cell C detected by the voltage detection circuit 112 may have a non-negligible difference from the OCV corresponding to the actual SOC of the battery cell C.

Referring to FIGS. 1 to 5, in step S510, the control unit 130 determines the voltage value, the current value, and the pressure value of the battery cell C based on the voltage signal, the current signal, and the pressure signal collected from the sensing unit 110. At this time, the control unit 130 may additionally collect the temperature signal from the sensing unit 110 and additionally determine the temperature value.

In step S520, the control unit 130 compares the previous SOC estimation value with the plateau section (Z_{A} to Z_{B}).

In step S530, according to the result of the comparison performed in step S520, the control unit 130 determines the current SOC estimation value by executing at least one of (i) a first SOC estimation logic based on the voltage value, the current value, and the first relationship data and (ii) a second SOC estimation logic based on the pressure value and the second relationship data.

The first SOC estimation logic may be designed to determine the OCV estimation value of the battery cell C based on the voltage value and the current value (temperature value may be added), and then output the SOC value associated with the OCV estimation value among the SOC values recorded in the first relationship data as the first SOC estimation value. The first SOC estimation logic may be designed to determine the OCV estimation value by subtracting the voltage value due to the internal resistance from the voltage value representing the CCV of the battery cell C while the SOC estimation value of the battery cell C is outside the plateau section (Z_{A} to Z_{B}). While the SOC estimation value of the battery cell C is within the plateau section (Z_{A} to Z_{B}), the first SOC estimation logic may be designed to determine the first SOC estimation value to be equal to the value obtained by adding the SOC change amount corresponding to the ampere integration amount calculated while the SOC estimation value of the battery cell C is staying in the plateau section (Z_{A} to Z_{B}) to the past SOC estimation value obtained immediately before the SOC estimation value enters the plateau section (Z_{A} to Z_{B}).

The second SOC estimation logic may be designed to output the SOC value associated with the pressure value determined in step S510 among the pressure values recorded in the second relationship data as the second SOC estimation value.

Accordingly, the current SOC estimation value determined in step S530 is equal to any one of the first SOC estimation value, the second SOC estimation value, and the weighted average thereof.

The 'current SOC estimation value' determined in step S530 becomes the 'previous SOC estimation value' to be compared with the plateau section (Z_{A} to Z_{B}) in step S520 when the method of FIG. 5 is executed again. Additionally, the control unit 130 sequentially records the SOC estimation value in the memory 120 each time step S530 is executed, and accordingly, a change history (time series) of the SOC estimation value is generated in the memory 120.

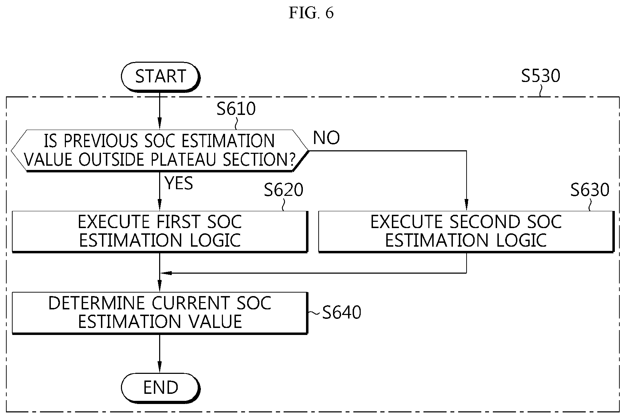

FIG. 6 is a flowchart illustrating the subroutine of step S530 of FIG. 5.

Referring to FIGS. 1 to 6, in step S610, the control unit 130 determines whether the previous SOC estimation value is outside the plateau section (Z_{A} to Z_{B}), that is, is less than the lower limit (Z_{A}) of the plateau section (Z_{A} to Z_{B}) or greater than the upper limit (Z_{B}) of the section (Z_{A} to Z_{B}). If the value of step S610 is "Yes," the process proceeds to step S620. The value of step S610 being "No" means that the previous SOC estimation value is within the plateau section (Z_{A} to Z_{B}). If the value in step S610 is "No", the process proceeds to step S630.

In step S620, the control unit 130 executes only the first SOC estimation logic among the first SOC estimation logic and the second SOC estimation logic. Accordingly, the first SOC estimation value is obtained.

In step S630, the control unit 130 executes only the second SOC estimation logic among the first SOC estimation logic and the second SOC estimation logic. Accordingly, the second SOC estimation value is obtained.

In step S640, the control unit 130 determines the current SOC estimation value to be equal to the first SOC estimation value obtained in step S620 or the second SOC estimation value obtained in step S630.

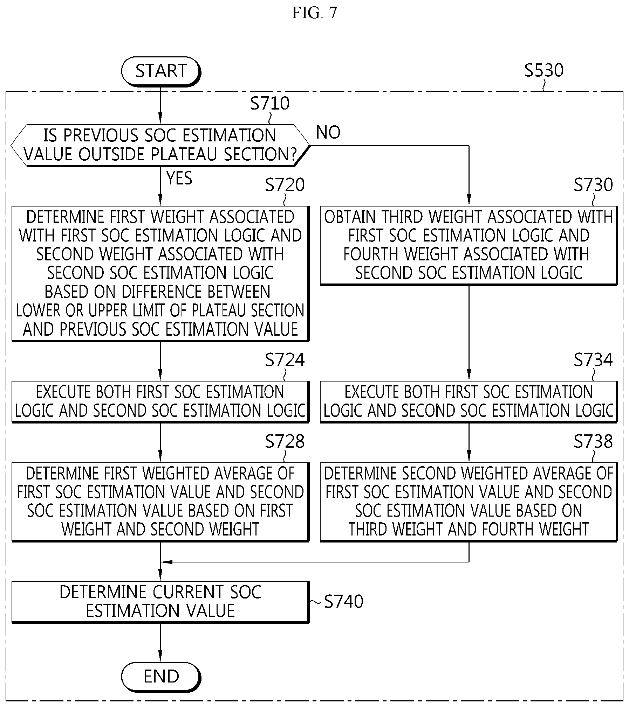

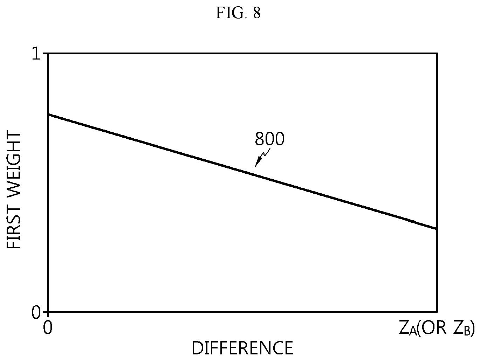

FIG. 7 is a flowchart illustrating another subroutine of step S530 of FIG. 5, and FIG. 8 is an example of a weight map that can be used in the subroutine of FIG. 7.

Referring to FIGS. 1 to 5, 7, and 8, in step S710, the control unit 130 determines whether the previous SOC estimation value is outside the plateau section (Z_{A} to Z_{B}). If the value of step S710 is "Yes," the process proceeds to step S720. If the value in step S710 is "No", the process proceeds to step S730.

In step S720, the control unit 130 determines the first weight associated with the first SOC estimation logic and the second weight associated with the second SOC estimation logic according to the difference between the lower limit (Z_{A}) or the upper limit (Z_{B}) of the plateau section (Z_{A} to Z_{B}) and the previous SOC estimation value. The first weight may have a negative correlation with the difference between the lower limit (Z_{A}) or the upper limit (Z_{B}) of the plateau section (Z_{A} to Z_{B}) and the previous SOC estimation value. The second weight may have a positive correlation with the difference between the lower limit (Z_{A}) or the upper limit (Z_{B}) of the plateau section (Z_{A} to Z_{B}) and the previous SOC estimation value. The sum of the first weight and the second weight may be a predetermined value (e.g., 1), and when one of the first weight and the second weight is determined, the other weight can also be determined.

FIG. 8 illustrates a weight map 800 in which the relationship between the first weight and the difference is recorded. The weight map 800 may be already stored in the memory 120. In FIG. 8, the difference being close to 0 means that the previous SOC estimation value is close to the plateau section (Z_{A} to Z_{B}), and the difference being close to the lower limit (Z_{A}) or the upper limit (Z_{B}) means that the previous SOC estimation value deviates far from the plateau section (Z_{A} to Z_{B}). If the previous SOC estimation value is less than the lower limit (Z_{A}), the lower limit (Z_{A}) may be set to the maximum value on the horizontal axis of FIG. 8, while if the previous SOC estimation value is greater than the upper limit (Z_{B}), the upper limit (Z_{B}) may be set to the maximum value on the horizontal axis of FIG. 8.

In step S724, the control unit 130 executes both the first SOC estimation logic and the second SOC estimation logic. Accordingly, the first SOC estimation value and the second SOC estimation value are obtained.

In step S728, the control unit 130 determines the first weighted average of the first SOC estimation value by the first SOC estimation logic and the second SOC estimation value by the second SOC estimation logic based on the first weight and the second weight. For example, if the first weight = 0.8, the second weight = 0.2, the first SOC estimation value = 25%, and the second SOC estimation value = 26%, the first weighted average = (first SOC estimation value × first weight) + (second SOC estimation value × second weight) = (25% × 0.8) + (26% × 0.2) = 20% + 5.2% = 25.2%.

In step S730, which is performed when the previous SOC estimation value is within the plateau section (Z_{A} to Z_{B}), the control unit 130 obtains the third weight associated with the first SOC estimation logic and the fourth weight associated with the second SOC estimation logic from the memory 120. Here, the third weight and the fourth weight may be predetermined values, unlike the first weight and the second weight, which are variable depending on the difference between the lower limit (Z_{A}) or the upper limit (Z_{B}) of the plateau section (Z_{A} to Z_{B}) and the previous SOC estimation value. The third weight may be less than or equal to the minimum value that can be set as the first weight. The fourth weight may be greater than or equal to the maximum value that can be set as the second weight. The sum of the third weight and the fourth weight may be a predetermined value (e.g., 1).

In step S734, the control unit 130 executes both the first SOC estimation logic and the second SOC estimation logic.

In step S738, the control unit 130 determines the second weighted average of the first SOC estimation value by the first SOC estimation logic and the second SOC estimation value by the second SOC estimation logic based on the third weight and the fourth weight. For example, if the third weight = 0.3, the fourth weight = 0.7, the first SOC estimation value = 60%, and the second SOC estimation value = 61%, the second weighted average = (first SOC estimation value × third weight) + (second SOC estimation value × fourth weight) = (60% × 0.3) + (61% × 0.7) = 18% + 42.7% = 60.7%.

In step S740, the control unit 130 determines the current SOC estimation value to be equal to the first weighted average obtained in step S728 or the second weighted average obtained in step S738.

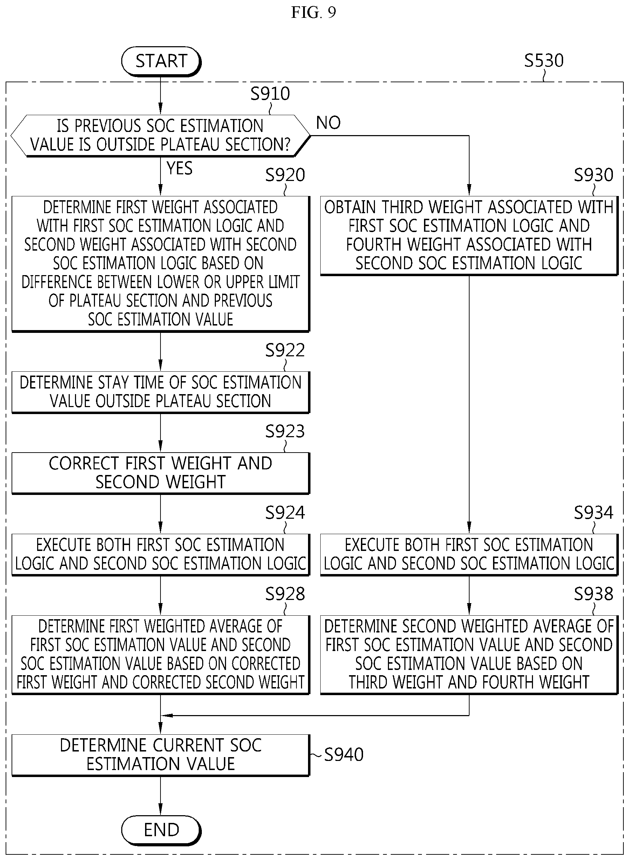

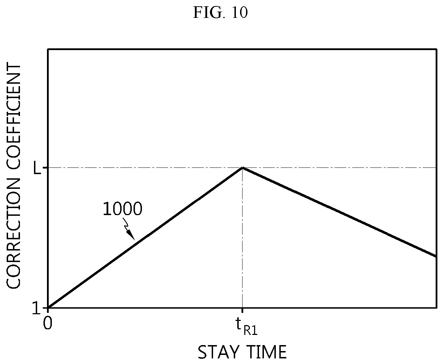

FIG. 9 is a flowchart illustrating still another subroutine of step S530 of FIG. 5, and FIG. 10 is an example of a weight map that can be used in the subroutine of FIG. 9.

Referring to FIGS. 1 to 5, 9, and 10, in step S910, the control unit 130 determines whether the previous SOC estimation value is outside the plateau section (Z_{A} to Z_{B}). If the value of step S910 is "Yes," the process proceeds to step S920. If the value in step S910 is "No", the process proceeds to step S930.

In step S920, the control unit 130 determines the first weight associated with the first SOC estimation logic and the second weight associated with the second SOC estimation logic according to the difference between the lower limit (Z_{A}) or the upper limit (Z_{B}) of the plateau section (Z_{A} to Z_{B}) and the previous SOC estimation value. Since the operation in step S920 is the same as in step S720, repeated descriptions are omitted.

In step S922, the control unit 130 determines the stay time of the SOC estimation value outside the plateau section (Z_{A} to Z_{B}) based on the time series of the SOC estimation value. In other words, it is determined how long the SOC estimation value remains outside the plateau section (Z_{A} to Z_{B}) from the most recent time point when the SOC estimation value deviates from the plateau section (Z_{A} to Z_{B}).

In step S923, the control unit 130 corrects the first weight and the second weight based on the stay time determined in step S924.

FIG. 10 illustrates the first correction coefficient map 1000 in which the relationship between the correction coefficient used to correct the first weight and the stay time is recorded. The first correction coefficient map 1000 may be previously stored in the memory 120.

Referring to FIG. 10, until the stay time reaches a predetermined criterion time (t_{R1}), the correction coefficient for the first weight may have a positive correlation with the stay time. After the stay time reaches the criterion time (t_{R1}), the correction coefficient for the first weight may have a negative correlation with the stay time. The minimum value of the correction coefficient for the first weight may be 1. The threshold value (L) may be greater than 1 and may be a preset value to prevent overextension of the corrected first weight.

As the stay time outside the plateau section (Z_{A} to Z_{B}) is prolonged, the ampere integration error also accumulates, so the accuracy of the first SOC estimate determined by the first SOC estimation logic may gradually decrease. Therefore, if the criterion time (t_{R1}) is appropriately selected through prior experiment or simulation, it is possible to prevent the SOC estimation accuracy from deteriorating due to the SOC of the battery cell C staying too long outside the plateau section (Z_{A} to Z_{B}).

Relatedly, in FIG. 10, the correction coefficient for the first weight is shown to change linearly before and after the criterion time (t_{R1}), but this should be understood as a simple example.

The difference between the corrected first weight and the first weight and the difference between the corrected second weight and the second weight may each have a positive correlation with the stay time. The corrected first weight may be equal to the product of the correction coefficient determined in the first correction coefficient map 1000 and the first weight. Once the corrected first weight is determined, the control unit 130 may calculate the corrected second weight such that the sum of the corrected first weight and the corrected second weight is equal to the predetermined value (e.g., 1).

In step S924, the control unit 130 executes both the first SOC estimation logic and the second SOC estimation logic.

In step S928, the control unit 130 determines the first weighted average of the first SOC estimation value by the first SOC estimation logic and the second SOC estimation value by the second SOC estimation logic based on the corrected first weight and the corrected second weight. For example, if the corrected first weight = 0.81, the corrected second weight = 0.19, the first SOC estimation value = 25%, and the second SOC estimation value = 26%, the first weighted average = (first SOC estimation value × corrected first weight) + (second SOC estimation value × corrected second weight) = (25% × 0.81) + (26% × 0.19) = 20.25% + 4.94% = 25.19%.

That is, even if the first SOC estimation value and the second SOC estimation value are 25% and 26%, respectively, and are the same as the example described above with reference to FIG. 7, as the corrected first weight increases compared to the original first weight and the corrected second weight decreases compared to the original second weight according to the length of the stay time, it can be seen that the first weighted average is also shifted to 25.19%, which is closer to the first SOC estimation value than 25.2% illustrated with reference to FIG. 7.

In step S930, the control unit 130 obtains a third weight associated with the first SOC estimation logic and a fourth weight associated with the second SOC estimation logic from the memory 120. Since descriptions of the third weight and the fourth weight may be common to those described above with reference to FIG. 7, repeated descriptions will be omitted.

In step S934, the control unit 130 executes both the first SOC estimation logic and the second SOC estimation logic.

In step S938, the control unit 130 determines the second weighted average of the first SOC estimation value by the first SOC estimation logic and the second SOC estimation value by the second SOC estimation logic, based on the third weight and the fourth weight.

In step S940, the control unit 130 determines the current SOC estimation value to be equal to the first weighted average obtained in step S928 or the second weighted average obtained in step S938.

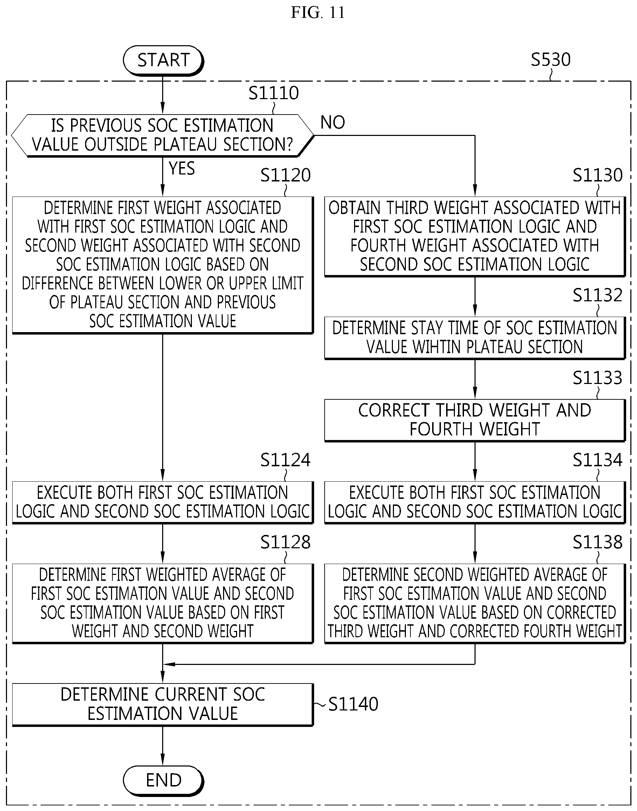

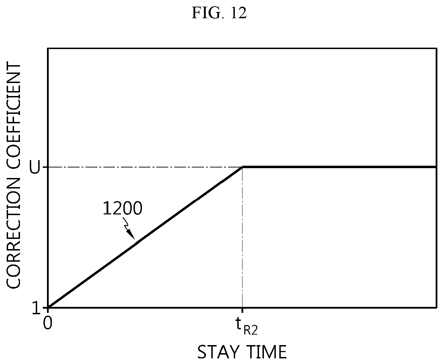

FIG. 11 is a flowchart illustrating still another subroutine of step S530 of FIG. 5, and FIG. 12 is an example of a weight map that can be used in the subroutine of FIG. 11.

Referring to FIGS. 1 to 5, 11, and 12, in step S1110, the control unit 130 determines whether the previous SOC estimation value is outside the plateau section (Z_{A} to Z_{B}). If the value of step S1110 is "Yes," the flow proceeds to step S1120. If the value of step S1110 is "No", the process proceeds to step S1130.

In step S1120, the control unit 130 determines the first weight associated with the first SOC estimation logic and the second weight associated with the second SOC estimation logic according to the difference between the lower limit (Z_{A}) or the upper limit (Z_{B}) of the plateau section (Z_{A} to Z_{B}) and the previous SOC estimation value. Since the operation in step S1120 is the same as in step S720, repeated description is omitted.

In step S1124, the control unit 130 executes both the first SOC estimation logic and the second SOC estimation logic. Accordingly, the first SOC estimation value and the second SOC estimation value are obtained.

In step S1128, the control unit 130 determines the first weighted average of the first SOC estimation value by the first SOC estimation logic and the second SOC estimation value by the second SOC estimation logic based on the first weight and the second weight.

In step S1130, the control unit 130 obtains a third weight associated with the first SOC estimation logic and a fourth weight associated with the second SOC estimation logic from the memory 120.

In step S1132, the control unit 130 determines a stay time of the SOC estimation value within the plateau section (Z_{A} to Z_{B}) based on the time series of the SOC estimation value. In other words, it is determined how long the SOC estimation value stays within the plateau section (Z_{A} to Z_{B}) from the most recent time point when the SOC estimation value enters the plateau section (Z_{A} to Z_{B}).

In step S1133, the control unit 130 corrects the third weight and the fourth weight based on the stay time determined in step S1134.

FIG. 12 illustrates the second correction coefficient map 1200 in which the relationship between the correction coefficient used to correct the fourth weight and the stay time is recorded. The second correction coefficient map 1200 may be previously stored in the memory 120. Referring to FIG. 12, until the stay time reaches the predetermined criterion time (t_{R2}), the correction coefficient may have a positive correlation with the stay time, and while the stay time is greater than the criterion time (t_{R2}), the correction coefficient may be maintained as a threshold value (U). The threshold value (U) may be greater than 1 and may be a preset value to prevent the corrected fourth weight from being excessive.

Relatedly, in FIG. 12, the correction coefficient for the fourth weight is shown to change linearly in a time range equal to or lower than the criterion time (t_{R2}), but this should be understood as a simple example.

The difference between the corrected third weight and the third weight and the difference between the corrected fourth weight and the fourth weight may each have a positive correlation with the stay time. The corrected fourth weight may be equal to the product of the correction coefficient determined in the second correction coefficient map 1200 and the fourth weight. Once the corrected fourth weight is determined, the control unit 130 may calculate the corrected third weight such that the sum of the corrected third weight and the corrected fourth weight is equal to the predetermined value (e.g., 1).

In step S1134, the control unit 130 executes both the first SOC estimation logic and the second SOC estimation logic. Accordingly, the first SOC estimation value and the second SOC estimation value are obtained.

When the corrected third weight and the corrected fourth weight are determined, in step S1138, the control unit 130 determines the second weighted average of the first SOC estimation value by the first SOC estimation logic and the second SOC estimation value by the second SOC estimation logic based on the corrected third weight and the corrected fourth weight. For example, if the corrected third weight = 0.25, the corrected fourth weight = 0.75, the first SOC estimation value = 60%, and the second SOC estimation value = 61%, the second weighted average = (first SOC estimation value × corrected third weight) + (second SOC estimation value × corrected fourth weight) = (60% × 0.25) + (61% × 0.75) = 15% + 45.75% = 60.75%.

That is, even if the first SOC estimation value and the second SOC estimation value are 60% and 61%, respectively, and are the same as the example in FIG. 7, as the corrected third weight decreases compared to the original third weight and the corrected fourth weight increases compared to the original fourth weight according to the length of the stay time, it can be seen that the second weighted average is shifted to 60.75%, which is closer to the second SOC estimation value than 60.7% according to FIG. 7.

In step S1140, the control unit 130 determines the current SOC estimation value to be equal to the first weighted average obtained in step S1128 or the second weighted average obtained in step S1138.

Meanwhile, the correction operation for the first and second weights described above with reference to FIGS. 9 and 10 and the correction operation for the third and fourth weights described with reference to FIGS. 11 and 12 are not implemented alternatively, and the battery management system 100 may be configured to enable correction of any of the first to fourth weights in step S530.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many substitutions, modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

## Claims

1. A battery management system (100) for a battery cell having a plateau section that is a State of Charge, SOC, range in which a change rate of Open Circuit Voltage, OCV, is maintained at a reference value or less, comprising:
a sensing unit (110) configured to detect voltage, current, and pressure of the battery cell;
a memory (120) configured to store first relationship data representing a relationship between OCV and SOC of the battery cell and second relationship data representing a relationship between pressure and SOC of the battery cell; and
a control unit (130) configured to determine a voltage value representing the detected voltage, a current value representing the detected current, and a pressure value representing the detected pressure, and determine a SOC estimation value of the battery cell at each set time,
wherein the control unit is configured to:
compare a previous SOC estimation value with the plateau section, and
according to the result of the comparison, determine a current SOC estimation value to be equal to any one of or a weighted average of two of (i) a first SOC estimation value obtained using a first SOC estimation logic based on the voltage value, the current value and the first relationship data, and (ii) a second SOC estimation value obtained using a second SOC estimation logic based on the pressure value and the second relationship data.

2. The battery management system according to claim 1, wherein the control unit is configured to determine the current SOC estimation value to be equal to the first SOC estimation value, when the previous SOC estimation value is outside the plateau section.

3. The battery management system according to claim 1, wherein the control unit is configured to determine the current SOC estimation value to be equal to the second SOC estimation value, when the previous SOC estimation value is within the plateau section.

4. The battery management system according to claim 1, wherein when the previous SOC estimation value is outside the plateau section, the control unit is configured to:
determine a first weight associated with the first SOC estimation logic and a second weight associated with the second SOC estimation logic based on a difference between a lower limit or an upper limit of the plateau section and the previous SOC estimation value, and
determine the current SOC estimation value to be equal to a first weighted average of the first SOC estimation value and the second SOC estimation value based on the first weight and the second weight.

5. The battery management system according to claim 4, wherein the first weight has a negative correlation to the difference between the lower limit or the upper limit of the plateau section and the previous SOC estimation value, and
wherein the second weight has a positive correlation to the difference between the lower limit or the upper limit of the plateau section and the previous SOC estimation value.

6. The battery management system according to claim 4, wherein when the previous SOC estimation value is within the plateau section, the control unit is configured to determine the current SOC estimation value to be equal to a second weighted average of the first SOC estimation value and the second SOC estimation value based on a third weight associated with the first SOC estimation logic and a fourth weight associated with the second SOC estimation logic,
wherein the third weight is less than the first weight, and
wherein the fourth weight is greater than the second weight.

7. The battery management system according to claim 4, wherein when the previous SOC estimation value is within the plateau section, the control unit is configured to:
determine a stay time of the SOC estimation value within the plateau section based on a time series of the SOC estimation value,
correct a third weight associated with the first SOC estimation logic and a fourth weight associated with the second SOC estimation logic based on the stay time, and
determine the current SOC estimation value to be equal to a second weighted average of the first SOC estimation value and the second SOC estimation value based on the corrected third weight and the corrected fourth weight,
wherein the third weight is less than the first weight, and
wherein the fourth weight is greater than the second weight.

8. The battery management system according to claim 7, wherein the corrected third weight is less than or equal to the third weight,
wherein the corrected fourth weight is greater than or equal to the fourth weight, and
wherein the difference between the corrected third weight and the third weight and the difference between the corrected fourth weight and the fourth weight have a positive correlation to the stay time, respectively.

9. The battery management system according to claim 1, wherein when the previous SOC estimation value is outside the plateau section, the control unit is configured to:
determine a first weight associated with the first SOC estimation logic and a second weight associated with the second SOC estimation logic based on a difference between the lower limit or the upper limit of the plateau section and the previous SOC estimation value,
determine a stay time of the SOC estimation value outside the plateau section based on a time series of the SOC estimation value,
correct the first weight and the second weight based on the stay time, and
determine the current SOC estimation value to be equal to a first weighted average of the first SOC estimation value and the second SOC estimation value based on the corrected first weight and the corrected second weight,
wherein the third weight is less than the first weight, and
wherein the fourth weight is greater than the second weight.

10. A battery pack (10), comprising the battery management system according to any one of claims 1 to 9.

11. An electric vehicle (1), comprising the battery pack according to claim 10.

12. A battery management method executed at each set time by the battery management system according to any one of claims 1 to 9, comprising:
determining a voltage value representing a voltage of the battery cell, a current value representing a current of the battery cell, and a pressure value representing a pressure of the battery cell;
comparing a previous SOC estimation value of the battery cell having the plateau section; and
according to the result of the comparison, determining a current SOC estimation value of the battery cell to be equal to any one of or a weighted average of two of (i) a first SOC estimation value obtained using a first SOC estimation logic based on the voltage value, the current value and the first relationship data, and (ii) a second SOC estimation value obtained using a second SOC estimation logic based on the pressure value and the second relationship data.

13. The battery management method according to claim 12, wherein the step of determining a current SOC estimation value of the battery cell includes:
determining the current SOC estimation value to be equal to the first SOC estimation value, when the previous SOC estimation value is outside the plateau section, and
determining the current SOC estimation value to be equal to the second SOC estimation value, when the previous SOC estimation value is within the plateau section.

14. The battery management method according to claim 12, wherein the step of determining a current SOC estimation value of the battery cell includes:
when the previous SOC estimation value is outside the plateau section, determining a first weight associated with the first SOC estimation logic and a second weight associated with the second SOC estimation logic based on a difference between a lower limit or an upper limit of the plateau section and the previous SOC estimation value, and
determining the current SOC estimation value to be equal to a first weighted average of the first SOC estimation value and the second SOC estimation value based on the first weight and the second weight.

15. The battery management method according to claim 12, wherein the step of determining a current SOC estimation value of the battery cell includes:
when the previous SOC estimation value is within the plateau section, obtaining a third weight associated with the first SOC estimation logic and a fourth weight associated with the second SOC estimation logic, and
determining the current SOC estimation value to be equal to a second weighted average of the first SOC estimation value and the second SOC estimation value based on the third weight and the fourth weight,
wherein the third weight is less than the first weight, and
wherein the fourth weight is greater than the second weight.

## Patentansprüche

1. Batteriemanagementsystem (100) für eine Batteriezelle mit einem Plateauabschnitt, der ein Ladezustands-, SOC-, Bereich ist, in dem eine Änderungsrate einer Leerlaufspannung, OCV, auf einem Referenzwert oder weniger gehalten wird, aufweisend:
eine Erfassungseinheit (110), die konfiguriert ist, eine Spannung, einen Strom und einen Druck der Batteriezelle zu erfassen;
einen Speicher (120), der konfiguriert ist, erste Relationssdaten, die eine Beziehung zwischen OCV und SOC der Batteriezelle darstellen, und zweite Relationssdaten, die eine Beziehung zwischen Druck und SOC der Batteriezelle darstellen, zu speichern; und
eine Steuereinheit (130), die konfiguriert ist, einen Spannungswert, der die erfasste Spannung darstellt, einen Stromwert, der den erfassten Strom darstellt, und einen Druckwert, der den erfassten Druck darstellt, zu bestimmen und einen SOC-Schätzwert der Batteriezelle zu jeder eingestellten Zeit zu bestimmen,
wobei die Steuereinheit konfiguriert ist:
einen vorherigen SOC-Schätzwert mit dem Plateauabschnitt zu vergleichen, und
gemäß dem Ergebnis des Vergleichs einen aktuellen SOC-Schätzwert so zu bestimmen, dass er gleich einem oder einem gewichteten Mittelwert von zwei von (i) einem ersten SOC-Schätzwert, der unter Verwendung einer ersten SOC-Schätzlogik basierend auf dem Spannungswert, dem Stromwert und den ersten Relationssdaten erhalten wird, und (ii) einem zweiten SOC-Schätzwert, der unter Verwendung einer zweiten SOC-Schätzlogik basierend auf dem Druckwert und den zweiten Relationssdaten erhalten wird, ist.

2. Batterieverwaltungssystem nach Anspruch 1, wobei die Steuereinheit konfiguriert ist, den aktuellen SOC-Schätzwert so zu bestimmen, dass er gleich dem ersten SOC-Schätzwert ist, wenn der vorherige SOC-Schätzwert außerhalb des Plateauabschnitts liegt.

3. Batterieverwaltungssystem nach Anspruch 1, wobei die Steuereinheit konfiguriert ist, den aktuellen SOC-Schätzwert so zu bestimmen, dass er gleich dem zweiten SOC-Schätzwert ist, wenn der vorherige SOC-Schätzwert innerhalb des Plateauabschnitts liegt.

4. Batterieverwaltungssystem nach Anspruch 1, wobei, wenn der vorherige SOC-Schätzwert außerhalb des Plateauabschnitts liegt, die Steuereinheit konfiguriert ist:
ein erstes Gewicht, das der ersten SOC-Schätzlogik zugeordnet ist, und ein zweites Gewicht, das der zweiten SOC-Schätzlogik zugeordnet ist, basierend auf einer Differenz zwischen einer Untergrenze oder einer Obergrenze des Plateauabschnitts und dem vorherigen SOC-Schätzwert zu bestimmen, und
den aktuellen SOC-Schätzwert so zu bestimmen, dass er gleich einem ersten gewichteten Mittelwert des ersten SOC-Schätzwerts und des zweiten SOC-Schätzwerts basierend auf dem ersten Gewicht und dem zweiten Gewicht ist.

5. Batterieverwaltungssystem nach Anspruch 4, wobei das erste Gewicht eine negative Korrelation zu der Differenz zwischen der Untergrenze oder der Obergrenze des Plateauabschnitts und dem vorherigen SOC-Schätzwert aufweist, und
wobei das zweite Gewicht eine positive Korrelation zu der Differenz zwischen der Untergrenze oder der Obergrenze des Plateauabschnitts und dem vorherigen SOC-Schätzwert aufweist.

6. Batterieverwaltungssystem nach Anspruch 4, wobei, wenn der vorherige SOC-Schätzwert innerhalb des Plateauabschnitts liegt, die Steuereinheit konfiguriert ist, den aktuellen SOC-Schätzwert so zu bestimmen, dass er gleich einem zweiten gewichteten Mittelwert des ersten SOC-Schätzwerts und des zweiten SOC-Schätzwerts basierend auf einem dritten Gewicht, das der ersten SOC-Schätzlogik zugeordnet ist, und einem vierten Gewicht, das der zweiten SOC-Schätzlogik zugeordnet ist, ist,
wobei das dritte Gewicht kleiner als das erste Gewicht ist, und
wobei das vierte Gewicht größer als das zweite Gewicht ist.

7. Batterieverwaltungssystem nach Anspruch 4, wobei, wenn der vorherige SOC-Schätzwert innerhalb des Plateauabschnitts liegt, die Steuereinheit konfiguriert ist:
eine Verweilzeit des SOC-Schätzwerts innerhalb des Plateauabschnitts basierend auf einer Zeitreihe des SOC-Schätzwerts zu bestimmen,
ein drittes Gewicht, das der ersten SOC-Schätzlogik zugeordnet ist, und ein viertes Gewicht, das der zweiten SOC-Schätzlogik zugeordnet ist, basierend auf der Verweilzeit zu korrigieren, und
den aktuellen SOC-Schätzwert so zu bestimmen, dass er gleich einem zweiten gewichteten Mittelwert des ersten SOC-Schätzwerts und des zweiten SOC-Schätzwerts basierend auf dem korrigierten dritten Gewicht und dem korrigierten vierten Gewicht ist,
wobei das dritte Gewicht kleiner als das erste Gewicht ist, und
wobei das vierte Gewicht größer als das zweite Gewicht ist.

8. Batterieverwaltungssystem nach Anspruch 7, wobei das korrigierte dritte Gewicht kleiner oder gleich dem dritten Gewicht ist,
wobei das korrigierte vierte Gewicht größer oder gleich dem vierten Gewicht ist, und
wobei die Differenz zwischen dem korrigierten dritten Gewicht und dem dritten Gewicht bzw. die Differenz zwischen dem korrigierten vierten Gewicht und dem vierten Gewicht eine positive Korrelation zu der Verweilzeit aufweisen.

9. Batterieverwaltungssystem nach Anspruch 1, wobei, wenn der vorherige SOC-Schätzwert außerhalb des Plateauabschnitts liegt, die Steuereinheit konfiguriert ist:
ein erstes Gewicht, das der ersten SOC-Schätzlogik zugeordnet ist, und ein zweites Gewicht, das der zweiten SOC-Schätzlogik zugeordnet ist, basierend auf einer Differenz zwischen der Untergrenze oder der Obergrenze des Plateauabschnitts und dem vorherigen SOC-Schätzwert zu bestimmen,
eine Verweilzeit des SOC-Schätzwerts außerhalb des Plateauabschnitts basierend auf einer Zeitreihe des SOC-Schätzwerts zu bestimmen,
das erste Gewicht und das zweite Gewicht basierend auf der Verweilzeit zu korrigieren, und
den aktuellen SOC-Schätzwert so zu bestimmen, dass er gleich einem ersten gewichteten Mittelwert des ersten SOC-Schätzwerts und des zweiten SOC-Schätzwerts basierend auf dem korrigierten ersten Gewicht und dem korrigierten zweiten Gewicht ist,
wobei das dritte Gewicht kleiner als das erste Gewicht ist, und
wobei das vierte Gewicht größer als das zweite Gewicht ist.

10. Batteriepack (10) aufweisend das Batterieverwaltungssystem nach einem der Ansprüche 1 bis 9.

11. Elektrofahrzeug (1) aufweisend den Batteriepack nach Anspruch 10.

12. Batterieverwaltungsverfahren, das zu jeder eingestellten Zeit durch das Batterieverwaltungssystem nach einem der Ansprüche 1 bis 9 ausgeführt wird, umfassend:
Bestimmen eines Spannungswerts, der eine Spannung der Batteriezelle darstellt, eines Stromwerts, der einen Strom der Batteriezelle darstellt, und eines Druckwerts, der einen Druck der Batteriezelle darstellt;
Vergleichen eines vorherigen SOC-Schätzwerts der Batteriezelle, die den Plateauabschnitt aufweist; und
gemäß dem Ergebnis des Vergleichs Bestimmen eines aktuellen SOC-Schätzwerts der Batteriezelle so, dass er gleich einem oder einem gewichteten Mittelwert von zwei von (i) einem ersten SOC-Schätzwert, der unter Verwendung einer ersten SOC-Schätzlogik basierend auf dem Spannungswert, dem Stromwert und den ersten Relationssdaten erhalten wird, und (ii) einem zweiten SOC-Schätzwert, der unter Verwendung einer zweiten SOC-Schätzlogik basierend auf dem Druckwert und den zweiten Relationssdaten erhalten wird, ist.

13. Batterieverwaltungsverfahren nach Anspruch 12, wobei der Schritt des Bestimmens eines aktuellen SOC-Schätzwerts der Batteriezelle umfasst:
Bestimmen des aktuellen SOC-Schätzwerts so, dass er gleich dem ersten SOC-Schätzwert ist, wenn der vorherige SOC-Schätzwert außerhalb des Plateauabschnitts liegt, und
Bestimmen des aktuellen SOC-Schätzwerts so, dass er gleich dem zweiten SOC-Schätzwert ist, wenn der vorherige SOC-Schätzwert innerhalb des Plateauabschnitts liegt.

14. Batterieverwaltungsverfahren nach Anspruch 12, wobei der Schritt des Bestimmens eines aktuellen SOC-Schätzwerts der Batteriezelle umfasst:
wenn der vorherige SOC-Schätzwert außerhalb des Plateauabschnitts liegt, Bestimmen eines ersten Gewichts, das der ersten SOC-Schätzlogik zugeordnet ist, und eines zweiten Gewichts, das der zweiten SOC-Schätzlogik zugeordnet ist, basierend auf einer Differenz zwischen einer Untergrenze oder einer Obergrenze des Plateauabschnitts und dem vorherigen SOC-Schätzwert, und
Bestimmen des aktuellen SOC-Schätzwerts so, dass er gleich einem ersten gewichteten Mittelwert des ersten SOC-Schätzwerts und des zweiten SOC-Schätzwerts basierend auf dem ersten Gewicht und dem zweiten Gewicht ist.

15. Batterieverwaltungsverfahren nach Anspruch 12, wobei der Schritt des Bestimmens eines aktuellen SOC-Schätzwerts der Batteriezelle umfasst:
wenn der vorherige SOC-Schätzwert innerhalb des Plateauabschnitts liegt, Erhalten eines dritten Gewichts, das der ersten SOC-Schätzlogik zugeordnet ist, und eines vierten Gewichts, das der zweiten SOC-Schätzlogik zugeordnet ist, und
Bestimmen des aktuellen SOC-Schätzwerts so, dass er gleich einem zweiten gewichteten Mittelwert des ersten SOC-Schätzwerts und des zweiten SOC-Schätzwerts basierend auf dem dritten Gewicht und dem vierten Gewicht ist,
wobei das dritte Gewicht kleiner als das erste Gewicht ist, und
wobei das vierte Gewicht größer als das zweite Gewicht ist.

## Revendications

1. Système de gestion de batterie (100) pour une cellule de batterie comprenant une section plateau, à savoir une plage de niveau de charge, SOC, dans laquelle un taux de variation de la tension en circuit ouvert, OCV, est maintenu à une valeur de référence, ou inférieure, comprenant ;
un module de détection (110) configuré pour détecter la tension, le courant, et la pression de la cellule de batterie ;
une mémoire (120) configurée pour stocker des premières données relationnelles représentant un rapport entre l'OCV et le SOC de la cellule de batterie, et des deuxièmes données relationnelles représentant un rapport entre la pression et le SOC de la cellule de batterie ; et
un module de commande (130) configuré pour déterminer une valeur de la tension représentant la tension détectée, une valeur du courant représentant le courant détecté, et une valeur de la pression représentant la pression détectée, et déterminer une valeur d'estimation du SOC de la cellule de batterie à chaque heure fixe,
le module de commande étant configuré pour :
comparer une valeur d'estimation précédente du SOC avec la section plateau, et
en fonction du résultat de la comparaison, déterminer un valeur d'estimation du SOC actuel qui soit égale à une quelconque (i) d'une première valeur d'estimation du SOC obtenue à l'aide d'une première logique d'estimation du SOC basée sur la valeur de la tension, la valeur du courant, et les premières données relationnelles, et (ii) d'une deuxième valeur d'estimation du SOC obtenue à l'aide d'une deuxième logique d'estimation du SOC basée sur la valeur de la pression et les deuxièmes données relationnelles, ou à une moyenne pondérée des deux.

2. Système de gestion de batterie selon la revendication 1, le module de commande étant configuré pour déterminer la valeur d'estimation du SOC actuel, qui soit égale à la première valeur d'estimation du SOC, lorsque la valeur d'estimation précédente du SOC se trouve hors de la section plateau.

3. Système de gestion de batterie selon la revendication 1, le module de commande étant configuré pour déterminer la valeur d'estimation du SOC actuel qui soit égale à la deuxième valeur d'estimation du SOC, lorsque la valeur d'estimation précédente du SOC se situe dans la section plateau.

4. Système de gestion de batterie selon la revendication 1, dans lequel lorsque la valeur d'estimation précédente du SOC se trouve en dehors de la section plateau, le module de commande est configuré pour :
déterminer une première pondération associée à la première logique d'estimation du SOC, et une deuxième pondération associée à la deuxième logique d'estimation du SOC, d'après une différence entre une limite inférieure ou une limite supérieure de la section plateau, et la valeur d'estimation précédente du SOC, et
déterminer la valeur d'estimation actuelle du SOC, qui soit égale à une première moyenne pondérée de la première valeur d'estimation du SOC et de la deuxième valeur d'estimation du SOC d'après la première pondération et la deuxième pondération.

5. Système de gestion de batterie selon la revendication 4, la première pondération présentant une corrélation négative avec la différence entre la limite inférieure ou la limite supérieure de la section plateau et la valeur d'estimation précédente du SOC, et
la deuxième pondération présentant une corrélation positive avec la différence entre la limite inférieure ou la limite supérieure de la section plateau et la valeur d'estimation précédente du SOC.

6. Système de gestion de batterie selon la revendication 4, dans lequel lorsque la valeur d'estimation précédente du SOC se situe dans la section plateau, le module de commande est configuré pour déterminer la valeur d'estimation du SOC actuel qui doit être égale à une deuxième moyenne pondérée de la première valeur d'estimation du SOC et de la deuxième valeur d'estimation du SOC d'après une troisième pondération associée à la première logique d'estimation du SOC et une quatrième pondération associée à la deuxième logique d'estimation du SOC,
la troisième pondération étant inférieure à la première pondération, et
la quatrième pondération étant supérieure à la deuxième pondération.

7. Système de gestion de batterie selon la revendication 4, dans lequel lorsque la valeur d'estimation précédente du SOC est comprise dans la section plateau, le module de commande est configuré pour
établir un temps de séjour de la valeur d'estimation du SOC au sein de la section plateau d'après une série temporelle de la valeur d'estimation du SOC,
corriger une troisième pondération associée à la première valeur d'estimation du SOC, et une quatrième pondération associée à la deuxième logique d'estimation du SOC en fonction du temps de séjour, et
établir que la valeur d'estimation actuelle du SOC est égale à une deuxième moyenne pondérée de la première valeur d'estimation du SOC et de la deuxième valeur d'estimation du SOC d'après la troisième pondération corrigée et la quatrième pondération corrigée,
la troisième pondération étant inférieure à la première pondération, et
la quatrième pondération étant supérieure à la deuxième pondération.

8. Système de gestion de batterie selon la revendication 7, la troisième pondération corrigée étant inférieure ou égale à la troisième pondération,
la quatrième pondération corrigée étant supérieure ou égale à la quatrième pondération, et
la différence entre la troisième pondération corrigée et la troisième pondération, et la différence entre la quatrième pondération corrigée et la quatrième pondération présentant une corrélation positive avec le temps de séjour respectivement.

9. Système de gestion de batterie selon la revendication 1, dans lequel lorsque la valeur d'estimation précédente du SOC se situe hors de la section plateau, le module de commande est configuré pour :
établir une première pondération associée à la première logique d'estimation du SOC, et une deuxième pondération associée à la deuxième logique d'estimation du SOC d'après une différence entre la limite inférieure ou la limite supérieure de la section plateau et la valeur d'estimation précédente du SOC,
établir un temps de séjour de la valeur d'estimation du SOC en dehors de la section plateau d'après une série temporelle de la valeur d'estimation du SOC,
corriger la première pondération et la deuxième pondération en fonction du temps de séjour, et
établir que la valeur d'estimation actuelle du SOC est égale à une première moyenne pondérée de la première valeur d'estimation du SOC et de la deuxième valeur d'estimation du SOC d'après la première pondération corrigée et la deuxième pondération corrigée,
la troisième pondération étant inférieure à la première pondération, et
la quatrième pondération étant supérieure à la deuxième pondération.

10. Bloc-batterie (10) comprenant le système de gestion de batterie selon une quelconque des revendications 1 à 9.

11. Véhicule électrique (1) comprenant bloc-batterie selon la revendication 10.

12. Procédé de gestion de batterie exécuté à chaque heure fixe par le système de gestion de batterie selon une quelconque des revendications 1 à 9, comprenant :
la détermination d'une valeur de tension représentant une tension de la cellule de batterie, une valeur de courant représentant un courant de la cellule de batterie, et une valeur de pression représentant une pression de la cellule de batterie ;
la comparaison d'une valeur d'estimation précédente du SOC de la cellule de batterie possédant la section plateau ; et
en fonction du résultat de la comparaison, la détermination d'une valeur d'estimation du SOC actuel de la cellule de batterie, qui soit égale à une quelconque (i) d'une première valeur d'estimation du SOC obtenue à l'aide d'une première logique d'estimation du SOC basée sur la valeur de la tension, la valeur du courant, et les premières données relationnelles, et (ii) d'une deuxième valeur d'estimation du SOC obtenue à l'aide d'une deuxième logique d'estimation du SOC basée sur la valeur de la pression et les deuxièmes données relationnelles, ou à une moyenne pondérée de deux de ces dernières.

13. Procédé de gestion de batterie selon la revendication 12, l'étape de détermination d'une valeur d'estimation actuelle du SOC de la cellule de batterie comprenant :
la détermination de la valeur d'estimation actuelle du SOC, qui soit égale à la première valeur d'estimation du SOC, lorsque la valeur d'estimation précédente du SOC se trouve en dehors de la section plateau, et
la détermination de la valeur d'estimation actuelle du SOC, qui soit égale à la deuxième valeur d'estimation du SOC, lorsque la valeur d'estimation précédente du SOC est comprise dans la section de plateau.

14. Procédé de gestion de batterie selon la revendication 12, l'étape de détermination d'une valeur d'estimation actuelle du SOC de la cellule de batterie comprenant :
la détermination, lorsque la valeur d'estimation précédente du SOC est en dehors de la section plateau, d'une première pondération associée à la première logique d'estimation du SOC, et d'une deuxième pondération associée à la deuxième d'estimation du SOC, d'après une différence entre une limite inférieure ou une limite supérieure de la section plateau et la valeur d'estimation précédente du SOC, et
la détermination de la valeur d'estimation actuelle du SOC, qui soit égale à une première moyenne pondérée de la première valeur d'estimation du SOC et de la deuxième valeur d'estimation du SOC d'après la première pondération et la deuxième pondération.

15. Procédé de gestion de batterie selon la revendication 12, l'étape de détermination d'une valeur d'estimation actuelle du SOC de la cellule de batterie comprenant :
l'obtention, lorsque la valeur d'estimation précédente du SOC est comprise dans la section de plateau, d'une troisième pondération associée à la première logique d'estimation du SOC, et d'une quatrième pondération associée à la deuxième logique d'estimation du SOC, et
la détermination de la valeur d'estimation actuelle du SOC, qui soit égale à une deuxième moyenne pondérée de la première valeur d'estimation du SOC et de la deuxième valeur d'estimation du SOC d'après la troisième pondération et la quatrième pondération,
la troisième pondération étant inférieure à la première pondération, et
la quatrième pondération étant supérieure à la deuxième pondération.
